# EUROPEAN PATENT SPECIFICATION

(11) **EP 4 590 108 B1**
(45) Date of publication and mention of the grant of the patent: **11.02.2026**
(21) Application number: 24219042.9
(22) Date of filing: 11.12.2024
(51) Int. Cl.: H10N 69/00, H10N 60/01, H10N 60/80

(54) **METHOD FOR MANUFACTURING QUBIT DEVICE**
VERFAHREN ZUR HERSTELLUNG EINER QUBIT-VORRICHTUNG
PROCÉDÉ DE FABRICATION DE DISPOSITIF À BITS QUANTIQUES

(30) Priority: 18.01.2024 JP 2024006158
(43) Date of publication of application: 23.07.2025
(73) Proprietor: Fujitsu Limited, Kawasaki-shi, Kanagawa 211-8588 (JP)
(72) Inventor: Takenouchi, Masatoshi, Kawasaki-shi, Kanagawa, 211-8588 (JP); Takahashi, Tsuyoshi, Kawasaki-shi, Kanagawa, 211-8588 (JP); Kouma, Norinao, Kawasaki-shi, Kanagawa, 211-8588 (JP)
(74) Representative: Hoffmann Eitle

(56) References cited:
- WO-A1-2023/132063
- WO-A1-2023/188391
- CN-A- 115 700 217
- US-B1- 9 836 699

## Description

### FIELD

The embodiment discussed herein is related to a method of manufacturing a qubit device.

### BACKGROUND

A qubit device in which a member having a recess portion is bonded to a substrate over which a qubit is provided by using a bonding material such as a bump and the qubit is disposed in a void formed by the recess portion has been known. A configuration in which a via is formed in the substrate over which the qubit is provided has been also known.

Japanese National Publication of International Patent Application No. 2019-532520, Japanese Laid-open Patent Publication No. 2020-61554, Japanese National Publication of International Patent Application No. 2022-530310, CN 115 700 217 A, WO 2023 / 132063 A1, WO 2023 / 188391 A1 and US 9 836 699 B1 are disclosed as related arts. None of these disclosures describes forming of a through-hole and removal of resist via the through- hole as defined by claim 1.

### SUMMARY

### TECHNICAL PROBLEM

In a case where the member having the recess portion is bonded to the substrate over which the qubit is provided by using a plurality of bonding materials, heights of the plurality of bonding materials may not be uniform due to manufacturing variation or the like. In this case, the bonding material having a small height may not sufficiently contribute to the bonding between the substrate and the member, and the member may be peeled off from the substrate.

In one aspect, an object is to suppress peeling of a member that covers a qubit from a substrate.

### SOLUTION TO PROBLEM

According to an aspect of the embodiments, there is provided a method for manufacturing a qubit device including: forming a first conductive film over a first surface of a qubit substrate; forming a qubit over the first surface; forming at least one through-hole that penetrates the qubit substrate in the qubit substrate; forming a resist over the first surface so as to cover the qubit and the through-hole; forming a second conductive film over the first conductive film and the resist; forming a first member over the second conductive film; and removing the resist from a second surface of the qubit substrate via the through-hole after the forming of the first member.

### ADVANTAGEOUS EFFECTS OF INVENTION

As one aspect, it is possible to suppress the peeling of the member that covers the qubit from the substrate.

### BRIEF DESCRIPTION OF DRAWINGS

FIG. 1 is a plan view of a qubit device according to an embodiment;
FIGs. 2A and 2B are sectional views of the qubit device according to the embodiment;
FIG. 3A is a plan view of a Josephson junction device according to the embodiment, FIG. 3B is a sectional view taken along line A-A in FIG. 3A, and FIG. 3C is a sectional view taken along line B-B in FIG. 3A;
FIGs. 4A to 4C are sectional views (part 1) illustrating a first manufacturing method of the qubit device according to the embodiment;
FIGs. 5A to 5C are sectional views (part 2) illustrating the first manufacturing method of the qubit device according to the embodiment;
FIGs. 6A to 6C are sectional views (part 3) illustrating the first manufacturing method of the qubit device according to the embodiment;
FIGs. 7A to 7C are diagrams (part 1) illustrating a method for manufacturing a Josephson junction device according to the embodiment;
FIGs. 8A and 8B are diagrams (part 2) illustrating the method for manufacturing the Josephson junction device according to the embodiment;
FIGs. 9A to 9C are sectional views (part 1) illustrating a second manufacturing method of the qubit device according to the embodiment;
FIGs. 10A to 10C are sectional views (part 2) illustrating the second manufacturing method of the qubit device according to the embodiment; and
FIGs. 11A to 11D are sectional views illustrating a method for manufacturing a qubit device according to a comparative example.

### DESCRIPTION OF EMBODIMENTS

Hereinafter, an embodiment of the present disclosure will be described with reference to the drawings.

### [Embodiment]

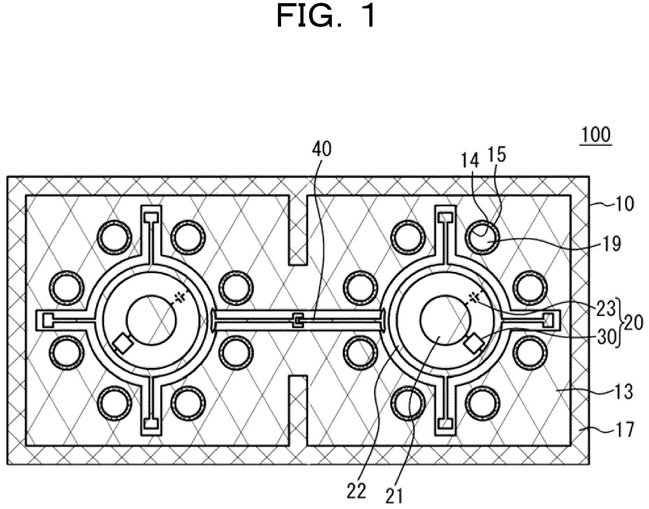

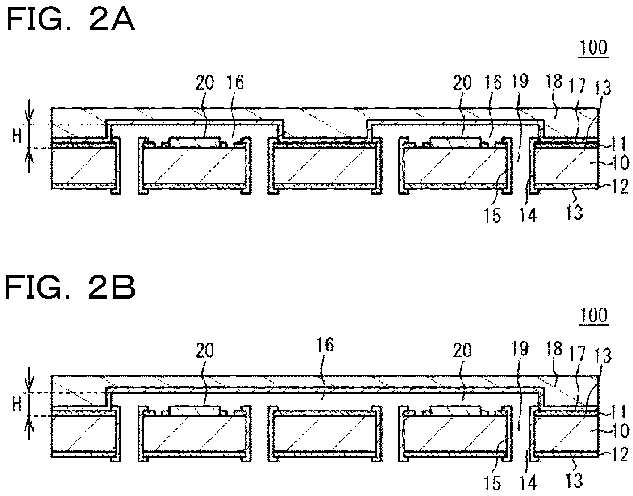

FIG. 1 is a plan view of a qubit device 100 according to the embodiment. FIGs. 2A and 2B are sectional views of the qubit device 100 according to the embodiment. FIG. 1 is a perspective view illustrating a first member 18 and a part of a conductive film 17 provided over a qubit substrate 10, and the conductive film is hatched for clarity of the drawing.

As illustrated in FIGs. 1, 2A, and 2B, in the qubit device 100 according to the embodiment, qubits 20 and a combination wiring 40 are provided over the qubit substrate 10. The qubit device 100 is used in a quantum computer that operates in a superconducting state under a very low temperature of, for example, several tens of milliKelvin (mK). The qubit 20 includes a Josephson junction device 30 coupled between a central electrode 21 and an outer peripheral electrode 22, and a capacitor 23 formed by the central electrode 21 and the outer peripheral electrode 22 facing each other.

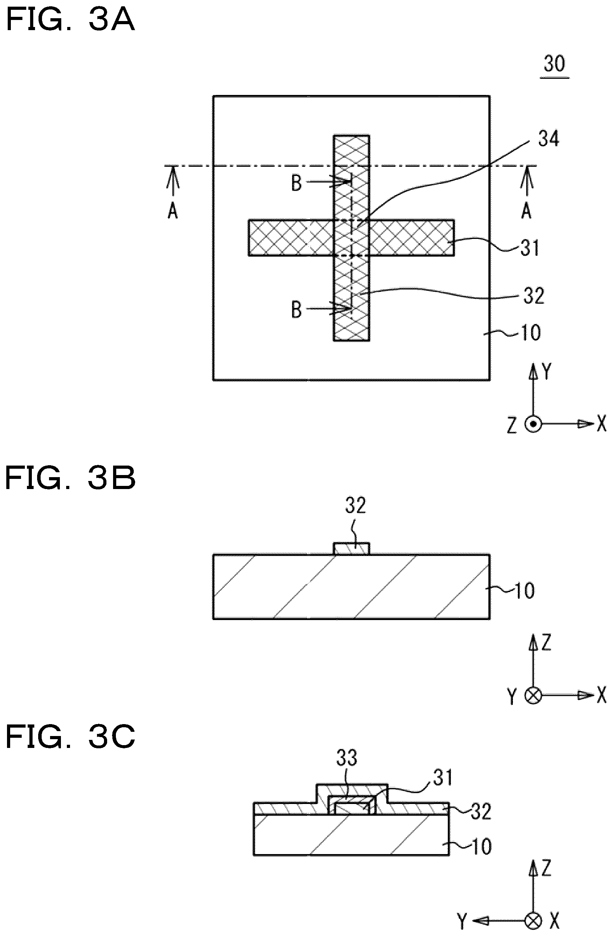

FIG. 3A is a plan view of the Josephson junction device 30 according to the embodiment, FIG. 3B is a sectional view taken along line A-A in FIG. 3A, and FIG. 3C is a sectional view taken along line B-B in FIG. 3A. An insulating film 33 provided over a surface of a superconducting film 31 is not illustrated in FIG. 3A. As illustrated in FIGs. 3A to 3C, the Josephson junction device 30 includes the superconducting film 31 extending in an X-axis direction, a superconducting film 32 extending in a Y-axis direction, and the insulating film 33 provided between the superconducting film 31 and the superconducting film 32 in a region where the superconducting film 31 and the superconducting film 32 overlap each other. For example, the insulating film 33 is provided to cover the surface of the superconducting film 31. The region where the superconducting film 31 and the superconducting film 32 overlap each other via the insulating film 33 is a Josephson junction portion 34. The superconducting films 31 and 32 are, for example, aluminum films. The insulating film 33 is, for example, an aluminum oxide film. The Josephson junction device 30 is coupled between the central electrode 21 and the outer peripheral electrode 22 by coupling one of the superconducting film 31 and the superconducting film 32 to the central electrode 21 and coupling the other to the outer peripheral electrode 22.

As illustrated in FIG. 1, 2A, and 2B, the combination wiring 40 is electrostatically combined with the qubits 20 and is a wiring that combines adjacent qubits 20. The qubit 20 and the combination wiring 40 are coupled to each other at a high frequency. A conductive film 13 is provided around the qubits 20 and the combination wiring 40 over an upper surface 11 of the qubit substrate 10 and over a lower surface 12 of the qubit substrate 10.

A plurality of through-holes 14 are provided around the qubit 20. The through-hole 14 is provided to penetrate from the upper surface 11 to the lower surface 12 of the qubit substrate 10. Over an inner wall of the through-hole 14, a conductive film 15 is provided from the upper surface 11 to the lower surface 12 of the qubit substrate 10. For example, the conductive film 15 is a via wiring that penetrates the qubit substrate 10. The conductive film 15 is in direct contact with the conductive film 13 over the upper surface 11 and the lower surface 12 of the qubit substrate 10. In the through-hole 14, a void 19 is formed inside the conductive film 15.

The conductive film 17 having an irregular shape is provided over the qubit substrate 10 such that a void 16 to which the qubit 20 is exposed is formed between the conductive film 17 and the qubit substrate 10. The conductive film 17 is provided in direct contact with the conductive film 13. A ground potential is supplied to the conductive film 17 via the conductive film 13 provided over the lower surface 12 of the qubit substrate 10, the conductive film 15 provided in the through-hole 14, and the conductive film 13 provided over the upper surface 11 of the qubit substrate 10. The void 16 is coupled to the void 19 of the through-hole 14. The first member 18 is provided over the conductive film 17 so as to cover the conductive film 17. The qubit 20 is protected by a laminate of the conductive film 17 and the first member 18.

The qubit substrate 10 is, for example, a semiconductor substrate or an insulating substrate such as a silicon substrate or a sapphire substrate. The central electrode 21, the outer peripheral electrode 22, the combination wiring 40, the conductive film 13, the conductive film 15, and the conductive film 17 are, for example, superconducting films, and are made of, for example, aluminum (Al), titanium nitride (TiN), niobium (Nb), or tantalum (Ta). The first member 18 is, for example, a film including a resin or an inorganic insulator, and is, for example, an epoxy resin film, a polyimide resin film, or a silicon oxide film.

FIG. 2A illustrates a case where the voids 16 to which adjacent qubits 20 are exposed, respectively, are separately formed, and FIG. 2B illustrates a case where adjacent qubits 20 are exposed to the common void 16. A plurality of qubits 20 are provided in the qubit device 100. All the qubits 20 may be exposed to the individual voids 16, respectively, or all the qubits 20 may be exposed to the common void 16. Some of the qubits 20 may be exposed to the individual voids 16, respectively, and some or all of the other qubits 20 may be exposed to the common void 16. At least some of the qubits 20 are exposed to the individual voids 16, respectively, and thus, mechanical strength of the laminate of the conductive film 17 and the first member 18 is increased. As a result, the voids 16 are less likely to be collapsed.

### [First Manufacturing Method]

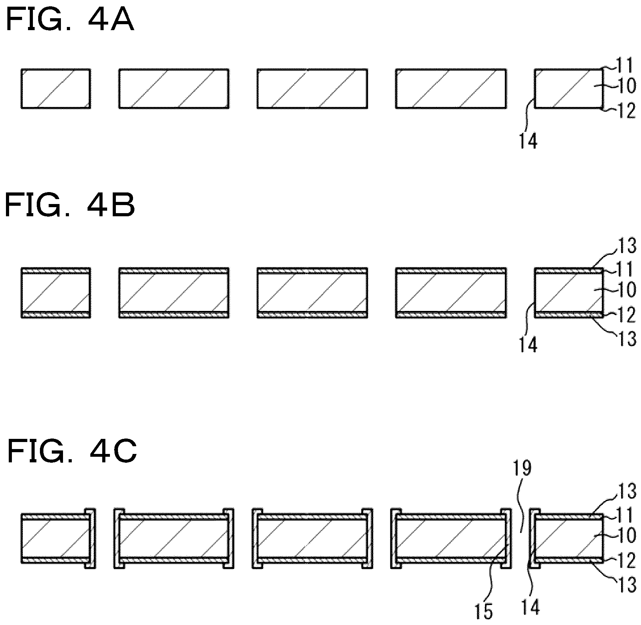

FIGs. 4A to 6C are sectional views illustrating a first manufacturing method of the qubit device 100 according to the embodiment. As illustrated in FIG. 4A, the qubit substrate 10 is etched by using, as a mask, a mask layer (not illustrated) formed over the upper surface 11 of the qubit substrate 10 which is, for example, a silicon substrate, and the through-hole 14 is formed in the qubit substrate 10. The through-hole 14 is formed to penetrate from the upper surface 11 to the lower surface 12 of the qubit substrate 10. The mask layer is a resist, for example, a patterned resist. For example, dry etching is used, and as an example, reactive ion etching using a Bosch process is used as the etching of the qubit substrate 10. The through-hole 14 is formed by alternately repeating, for example, etching of the qubit substrate 10 using an SF₆ gas as a fluorine-based gas and forming of a protective film over an inner wall of a hole etched by using an O₂ gas as an oxygen-based gas. Consequently, the through-hole 14 having a diameter of, for example, about 100 µm to 150 µm and a depth of about 250 µm to 350 µm is formed in the qubit substrate 10. The inner wall of the through-hole 14 is formed to be substantially vertical.

As illustrated in FIG. 4B, the conductive film 13 is formed over the upper surface 11 and the lower surface 12 of the qubit substrate 10 by using, for example, a sputtering method. The conductive film 13 is, for example, a titanium nitride (TiN) film and has a thickness of, for example, about 100 nm to 300 nm.

As illustrated in FIG. 4C, the conductive film 15 is formed over the inner wall of the through-hole 14 by using, for example, an oblique vacuum evaporation method using a stencil mask. The conductive film 15 extends from the upper surface 11 of the qubit substrate 10 to the lower surface 12 via the inner wall of the through-hole 14 and is formed in direct contact with the conductive film 13. In the through-hole 14, the void 19 is formed inside the conductive film 15. The conductive film 15 is, for example, an aluminum (Al) film and has a thickness of, for example, about 300 nm to 1000 nm.

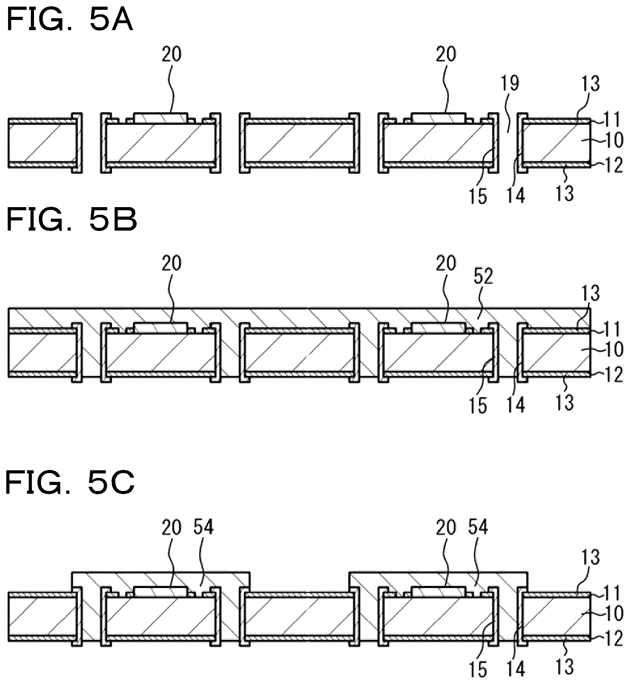

As illustrated in FIG. 5A, the conductive film 13 in a region where the qubit 20 is formed is removed. The removal of the conductive film 13 is performed by etching the conductive film 13 by using, as the mask, the mask layer (not illustrated) formed over the upper surface 11 of the qubit substrate 10. The conductive film 13 is etched at the same time, and thus, the central electrode 21, the outer peripheral electrode 22, and the combination wiring 40 (see FIG. 1) are formed. After the conductive film 13 is removed, the qubit 20 is formed by forming the Josephson junction device 30 in a region where the conductive film 13 is removed.

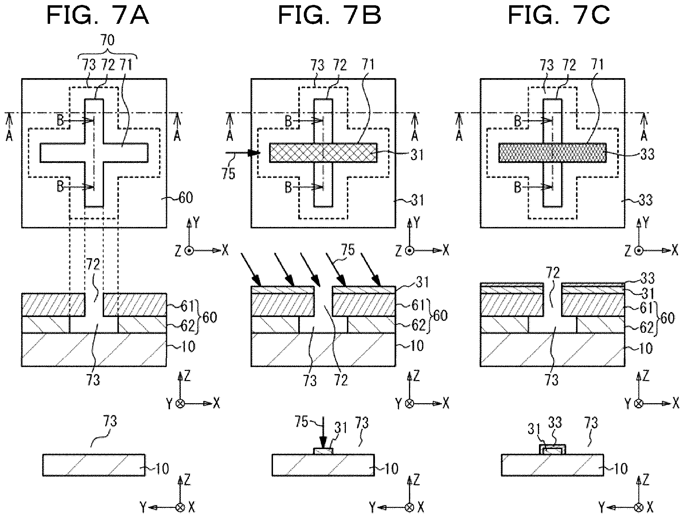

FIGs. 7A to 8B are diagrams illustrating a method for manufacturing the Josephson junction device 30 according to the embodiment. Diagrams at upper parts of FIGs. 7A to 8B are plan views illustrating the method for manufacturing the Josephson junction device 30. Diagrams at middle parts are sectional views taken along line A-A of the diagrams at the upper parts, and diagrams at lower parts are sectional views taken along line B-B of the diagrams at the upper parts. In the plan views at the upper parts of FIGs. 7B to 8B, the superconducting film 31, the superconducting film 32, and the insulating film 33 formed in a void 73 are hatched for clarity of the drawings.

As illustrated in FIG. 7A, a mask layer 60 is formed over the qubit substrate 10. The mask layer 60 includes an upper layer 61 and a lower layer 62. The mask layer 60 is made of a resist. A mask pattern 70 including an opening portion 71, an opening portion 72, and the void 73 is formed in the mask layer 60. The opening portion 71 extends in the X-axis direction, and the opening portion 72 extends in the Y-axis direction so as to intersect with the opening portion 71. Both the opening portions are formed in the upper layer 61. The void 73 is formed in the lower layer 62. The void 73 is positioned below the opening portions 71 and 72, and has a shape obtained by increasing shapes of the opening portions 71 and 72 in plan view. Widths of the opening portions 71 and 72 are, for example, about 100 nm to 300 nm.

As illustrated in FIG. 7B, the superconducting film 31 is formed over the qubit substrate 10 by using the mask layer 60 as a mask by the oblique vacuum evaporation method from above in a -X direction as indicated by an arrow 75. Since the superconducting film 31 is formed by the oblique vacuum evaporation method from above in the -X direction, a width dimension of the opening portion 72 is set to an appropriate size, and thus, the superconducting film 31 extending in the Y-axis direction is not formed in the void 73. Only the superconducting film 31 extending in the X-axis direction is formed in the void 73. The superconducting film 31 is, for example, an aluminum (Al) film and has a thickness of, for example, about 30 nm to 50 nm and a width of, for example, about 100 nm to 300 nm.

As illustrated in FIG. 7C, while a vacuum state when the superconducting film 31 is formed is maintained, oxygen is introduced into a chamber to oxidize the surface of the superconducting film 31, and thus, the insulating film 33 made of, for example, aluminum oxide (Al₂O₃) is formed over the surface of the superconducting film 31.

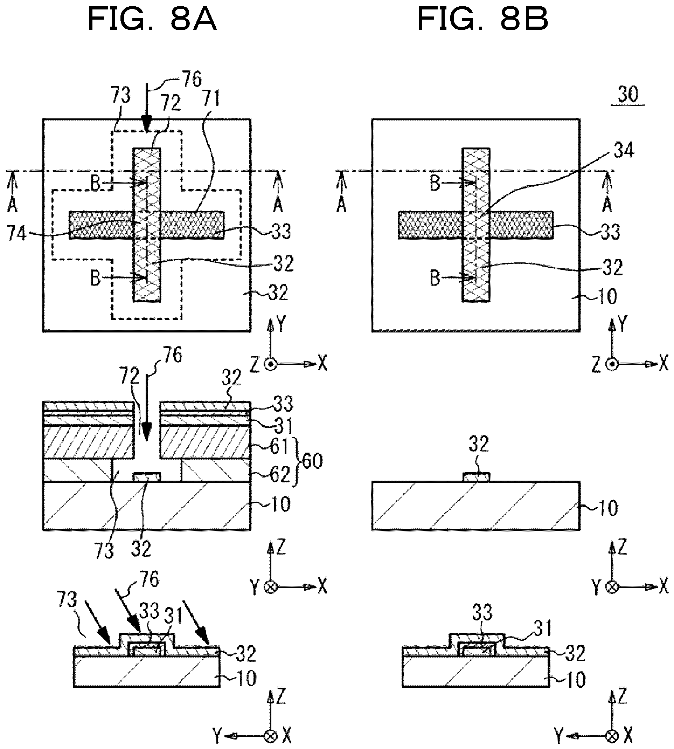

As illustrated in FIG. 8A, the superconducting film 32 is formed over the qubit substrate 10 by using the mask layer 60 as a mask by the oblique vacuum evaporation method from above in a +Y direction as indicated by an arrow 76. Since the superconducting film 32 is formed by the oblique vacuum evaporation method from above in the +Y direction, a width dimension of the opening portion 71 is set to an appropriate size, and thus, the superconducting film 32 extending in the X-axis direction is not formed in the void 73. Only the superconducting film 32 extending in the Y-axis direction is formed in the void 73. The superconducting film 32 is, for example, an aluminum (Al) film and has a thickness of, for example, 50 nm to 70 nm and a width of, for example, about 100 nm to 300 nm. Consequently, a region 74 where the superconducting film 31 extending in the X-axis direction and the superconducting film 32 extending in the Y-axis direction overlap each other via the insulating film 33 is formed.

As illustrated in FIG. 8B, the mask layer 60, and the superconducting film 31, the insulating film 33, and the superconducting film 32 formed over the mask layer 60 are removed by a lift-off method. The region 74 where the superconducting film 31 extending in the X-axis direction and the superconducting film 32 extending in the Y-axis direction overlap each other via the insulating film 33 serves as the Josephson junction portion 34.

As illustrated in FIG. 5B, a resist film 52 that covers the qubit 20 is applied onto the upper surface 11 of the qubit substrate 10 by using, for example, a spin coating method. The resist film 52 is also embedded in the void 19 in the through-hole 14. A thickness of the resist film 52 is, for example, about 150 µm to 300 µm.

As illustrated in FIG. 5C, patterning is performed by exposure, development, and the like such that the resist film 52 remains in a region where the void 16 (see FIGs. 2A and 2B) to which the qubit 20 is exposed is formed, and thus, a resist pattern 54 is formed. The resist pattern 54 is formed to cover the qubit 20 and the through-hole 14 and to be embedded in the void 19 in the through-hole 14.

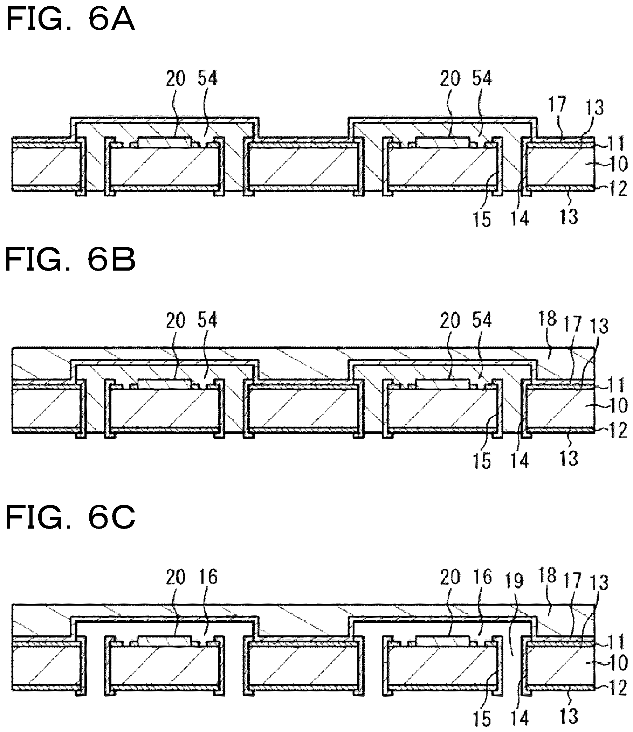

As illustrated in FIG. 6A, the conductive film 17 is formed over the conductive film 13 and the resist pattern 54 by using, for example, the oblique vacuum evaporation method. The conductive film 17 is, for example, an aluminum (Al) film and has a thickness of, for example, about 400 nm to 600 nm. The conductive film 17 is formed in direct contact with the conductive film 13.

As illustrated in FIG. 6B, the first member 18 is formed over the conductive film 17. The first member 18 is formed in direct contact with the conductive film 17. In order to suppress the influence on the qubit 20, the first member 18 is formed under a manufacturing condition of, for example, 150°C or lower, and preferably 100°C or lower. The first member 18 made of a silicon oxide film is formed by, for example, a low-temperature chemical vapor deposition (CVD) method using tetraethoxysilane (TEOS) as a raw material. For example, the first member 18 made of an epoxy resin film is formed by applying and curing a liquid epoxy resin. For example, film-shaped polyimide resins are bonded to each other to form the first member 18 made of a polyimide resin film. The first member 18 may be an inorganic insulating film other than a silicon oxide film, may be a resin film other than an epoxy resin film and a polyimide resin film, or may be other films. A thickness of the first member 18 is, for example, about 5 µm to 30 µm.

As illustrated in FIG. 6C, a peeling agent for removing the resist pattern 54 is introduced into the resist pattern 54 from the lower surface 12 of the qubit substrate 10 via the through-hole 14, and the resist pattern 54 is removed. Consequently, the resist pattern 54 over the qubit 20 is removed, and the void 16 to which the qubit 20 is exposed is formed between the qubit substrate 10 and the conductive film 17. A decrease in a coherence time of the qubit 20 is suppressed by exposing the qubit 20 to the void 16. The void 16 is formed so as to be coupled to the void 19 in the through-hole 14.

### [Second Manufacturing Method]

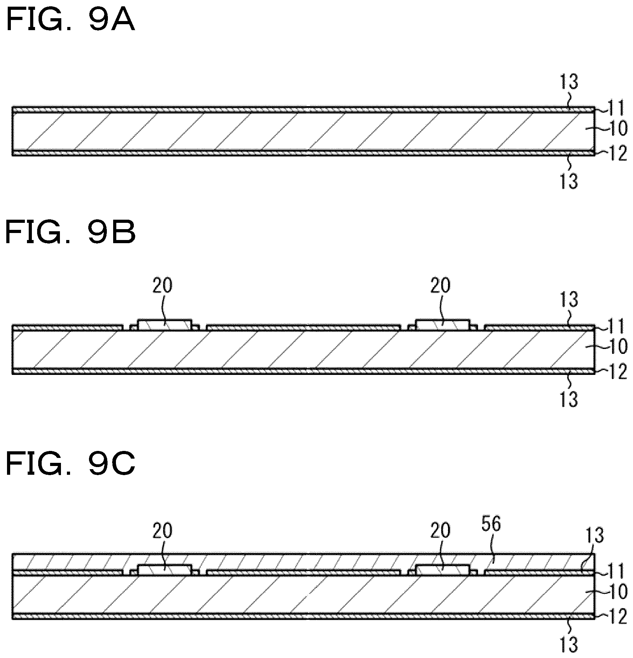

FIGs. 9A to 10C are sectional views illustrating a second manufacturing method of the qubit device 100 according to the embodiment. As illustrated in FIG. 9A, the conductive film 13 is formed over the upper surface 11 and the lower surface 12 of the qubit substrate 10, which is, for example, a silicon substrate, by using, for example, the sputtering method. The conductive film 13 is, for example, a titanium nitride (TiN) film and has a thickness of, for example, about 100 nm to 300 nm.

As illustrated in FIG. 9B, the conductive film 13 in the region where the qubit 20 is formed is removed. The removal of the conductive film 13 is performed by etching the conductive film 13 by using, as the mask, the mask layer (not illustrated) formed over the upper surface 11 of the qubit substrate 10. The conductive film 13 is etched at the same time, and thus, the central electrode 21, the outer peripheral electrode 22, and the combination wiring 40 (see FIG. 1) are formed. After the conductive film 13 is removed, the qubit 20 is formed by forming the Josephson junction device 30 in a region where the conductive film 13 is removed. The Josephson junction device 30 is formed by the manufacturing method illustrated in FIGs. 7A to 8B.

As illustrated in FIG. 9C, a protective film 56 that covers the conductive film 13 and the qubit 20 is formed over the upper surface 11 of the qubit substrate 10. The protective film 56 is, for example, a silicon oxide film formed by a low-temperature CVD method at 100°C or lower. The protective film 56 is provided to protect the qubit 20. A thickness of the protective film 56 is, for example, about 5 µm to 30 µm.

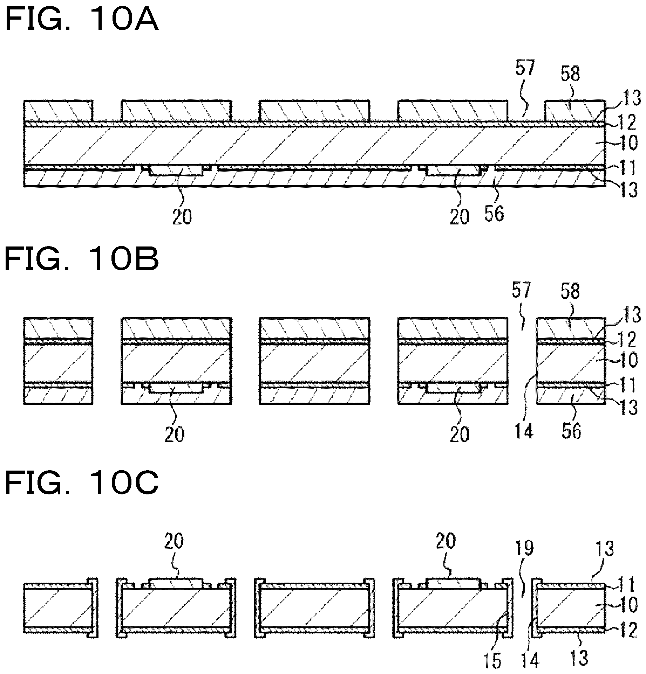

As illustrated in FIG. 10A, a mask layer 58 having an opening 57 in a region where the through-hole 14 is formed is formed over the lower surface 12 of the qubit substrate 10. The mask layer 58 is made of, for example, a resist.

As illustrated in FIG. 10B, the qubit substrate 10 and the protective film 56 are etched by using the mask layer 58 as a mask, and the through-hole 14 that penetrates the qubit substrate 10 from the lower surface 12 to the upper surface 11 is formed. For example, dry etching is used, and as an example, reactive ion etching using the Bosch process is used as the etching of the qubit substrate 10 and the protective film 56. Consequently, the through-hole 14 having a diameter of, for example, about 100 µm to 150 µm and a depth of about 250 µm to 350 µm is formed in the qubit substrate 10. The inner wall of the through-hole 14 is formed to be substantially vertical.

As illustrated in FIG. 10C, after the protective film 56 and the mask layer 58 are removed, the same step as the step illustrated in FIG. 4C in the first manufacturing method is performed to form the conductive film 15 over the inner wall of the through-hole 14. The conductive film 15 extends from the upper surface 11 of the qubit substrate 10 to the lower surface 12 via the inner wall of the through-hole 14 and is formed in direct contact with the conductive film 13. The conductive film 15 is, for example, an aluminum (Al) film and has a thickness of, for example, about 300 nm to 1000 nm.

Thereafter, the same steps as the steps illustrated in FIGs. 5B to 6C in the first manufacturing method are performed.

### [Comparative Example]

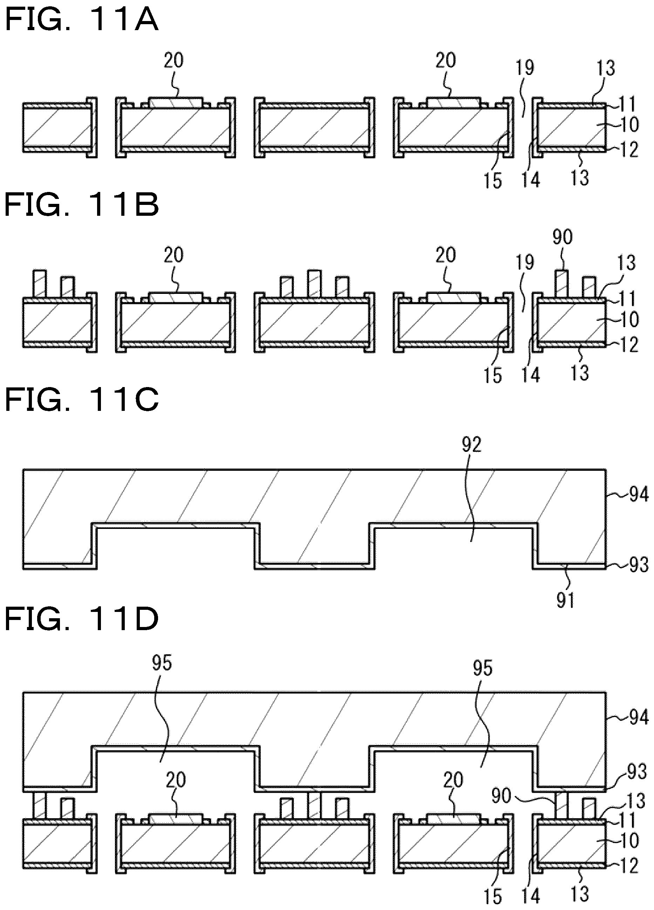

FIGs. 11A to 11D are sectional views illustrating a method for manufacturing a qubit device according to a comparative example. As illustrated in FIG. 11A, the same steps as the steps illustrated in FIGs. 4A to 5A of the embodiment are performed. As illustrated in FIG. 11B, a plurality of bonding materials 90 are formed over the conductive film 13 by using, for example, an evaporation method and the lift-off method. The bonding materials 90 are, for example, bumps, and are, as an example, indium (In) bumps.

As illustrated in FIG. 11C, a cover member 94 that has a recess portion 92 in a surface 91 and a conductive film 93 provided over the surface 91 along an inner surface of the recess portion 92 is separately manufactured. The recess portion 92 is formed by using, for example, a photolithography method and an etching method. The conductive film 93 is formed by, for example, the evaporation method. The cover member 94 is, for example, a silicon substrate, and the conductive film 93 is, for example, an aluminum (Al) film.

As illustrated in FIG. 11D, the conductive film 93 of the cover member 94 is bonded to the plurality of bonding materials 90. Consequently, a void 95 to which the qubit 20 is exposed is formed between the qubit substrate 10 and the cover member 94. The qubit 20 is protected by the conductive film 93 and the cover member 94.

In the comparative example, as illustrated in FIG. 11D, the cover member 94 is bonded to the qubit substrate 10 by the plurality of bonding materials 90. In this case, since the bonding materials 90 are formed by, for example, the evaporation method and the lift-off method, manufacturing variation in height may occur among the plurality of bonding materials 90. In order to suppress the influence on the qubit 20, the cover member 94 is preferably bonded to the bonding materials 90 at a low temperature. To this end, since the cover member 94 is pressed against the bonding materials 90 with a small load, when there is variation in height among the plurality of bonding materials 90, the bonding material 90 which is not bonded to the cover member 94 appears. In this case, a bonding force between the qubit substrate 10 and the cover member 94 is weakened, and the cover member 94 may be peeled off from the qubit substrate 10.

Consequently, in the embodiment, by the manufacturing method described above, the conductive film 17 and the first member 18 that protect the qubit 20 are formed over the qubit substrate 10. As illustrated in FIG. 4B or 9A, the conductive film 13 (first conductive film) is formed over the upper surface 11 (first surface) of the qubit substrate 10. As illustrated in FIG. 5A or 9B, the qubit 20 is formed over the upper surface 11 of the qubit substrate 10. As illustrated in FIG. 4A or 10B, at least one through-hole 14 that penetrates the qubit substrate 10 is formed in the qubit substrate 10. As illustrated in FIG. 5C, the resist pattern 54 (resist) is formed over the upper surface 11 of the qubit substrate 10 so as to cover the qubit 20 and the through-hole 14. As illustrated in FIG. 6A, the conductive film 17 (second conductive film) is formed over the conductive film 13 and the resist pattern 54. As illustrated in FIG. 6B, the first member 18 is formed over the conductive film 17. As illustrated in FIG. 6C, after the first member 18 is formed, the resist pattern 54 is removed from the lower surface 12 (second surface) of the qubit substrate 10 via the through-hole 14. By using such a manufacturing method, since a bonding force between the conductive film 13 and the conductive film 17 and a bonding force between the conductive film 17 and the first member 18 are increased, it is possible to suppress the conductive film 17 and the first member 18 from being peeled off from the qubit substrate 10.

In the embodiment, the ground potential is supplied to the conductive film 17. Consequently, an effect of shielding electromagnetic waves may be imparted to the conductive film 17. Consequently, it is possible to suppress the occurrence of hindrance to driving, a characteristic defect, and the like in the qubit 20 due to the electromagnetic waves.

In the embodiment, the conductive film 17 is a superconducting film. Since the qubit device 100 is used under a very low temperature of, for example, several tens of milliKelvin (mK), the conductive film 17 is in a superconducting state by being a superconducting film, and the conductive film 17 may be favorably set to the ground potential. Consequently, the shielding effect may be effectively imparted to the conductive film 17.

In the embodiment, as illustrated in FIG. 4C or 10C, the conductive film 15 (third conductive film) coupled to the conductive film 13 is formed over the inner surface of the through-hole 14. The ground potential is supplied to the conductive film 17 via the conductive film 13 and the conductive film 15. Consequently, the ground potential may be easily supplied to the conductive film 17.

In the embodiment, the conductive film 13, the conductive film 15, and the conductive film 17 are superconducting films. Consequently, even in a case where the temperature is very low, for example, several tens of milliKelvin (mK), the ground potential may be favorably supplied to the conductive film 17 via the conductive film 13 and the conductive film 15.

In the embodiment, the first member 18 is a film including a resin or an inorganic insulator. Consequently, unintended conduction of the conductive film 17 to another member may be suppressed. In a case where the first member 18 is a resin film, force from an outside is easily absorbed by the first member 18.

By the first manufacturing method of the embodiment, as illustrated in FIGs. 4A to 5A, the through-hole 14 that penetrates the qubit substrate 10 is formed before the qubit 20 is formed. As described above, the qubit 20 is formed after the through-hole 14 is formed, and thus, it is possible to suppress damage to the qubit 20 regardless of conditions used for forming the through-hole 14.

By the second manufacturing method of the embodiment, as illustrated in FIGs. 9B to 10C, after the qubit 20 is formed, the through-hole 14 that penetrates the qubit substrate 10 is formed. Consequently, since the qubit 20 may be formed in a state where there is no through-hole 14, the ease of forming the qubit 20 is improved.

In the embodiment, an interval H (see FIGs. 2A and 2B) from the upper surface 11 of the qubit substrate 10 to the conductive film 17 is preferably 40 µm or more, more preferably 60 µm or more, and still more preferably 80 µm or more. Consequently, since an electric field generated from the qubit 20 is easily drawn into the void 16 which is a free space, a dielectric loss is reduced. Consequently, deterioration in characteristics of the qubit 20 may be suppressed. Parasitic capacitance between the qubit 20 and the conductive film 17 is also reduced. Since a size of the device increases as the interval H increases, the interval H is preferably 200 µm or less, more preferably 180 µm or less, and still more preferably 160 µm or less. For example, the interval H is preferably 100 times or more, more preferably 200 times or more, and still more preferably 300 times or more the thickness of the conductive film 13. The interval H is preferably 700 times or less, more preferably 600 times or less, and still more preferably 500 times or less the thickness of the conductive film 13.

While the embodiment of the present disclosure has been described in detail above, the present disclosure is not limited to such a specific embodiment, and various modifications and alterations may be made within the invention as defined by the claims.

## Claims

1. A method for manufacturing a qubit device comprising:
forming a first conductive film (13) over a first surface (11) of a qubit substrate (10);
forming a qubit (20) over the first surface (11);
forming at least one through-hole (14) that penetrates the qubit substrate (10) in the qubit substrate (10);
forming a resist (54) over the first surface (11) so as to cover the qubit (20) and the through-hole (14);
forming a second conductive film (17) over the first conductive film (13) and the resist (54);
forming a first member (18) over the second conductive film (17); and
removing the resist (54) from a second surface (12) of the qubit substrate (10) via the through-hole (14) after the forming of the first member (18).

2. The method according to claim 1, wherein a ground potential is supplied to the second conductive film (17).

3. The method according to claim 2, wherein
the first conductive film (13) and the second conductive film (17) are superconducting films.

4. The method according to claim 1 or 2, further comprising:
forming a third conductive film (15) coupled to the first conductive film (13) over an inner surface of the through-hole (14), wherein a ground potential is supplied to the second conductive film (17) via the first conductive film (13) and the third conductive film (15).

5. The method according to claim 4, wherein
the first conductive film (13), the second conductive film (17), and the third conductive film (15) are superconducting films.

6. The method according to claim 1 or 2, wherein
the first member (18) is a film that includes a resin or an inorganic insulator.

7. The method according to claim 1 or 2, wherein
the forming of the through-hole (14) is performed before the forming of the qubit (20).

8. The method according to claim 1 or 2, wherein
the forming of the through-hole (14) is performed after the forming of the qubit (20).

## Patentansprüche

1. Verfahren zur Herstellung einer Qubit-Vorrichtung, umfassend:
Ausbilden eines ersten leitenden Films (13) über einer ersten Oberfläche (11) eines Qubit-Substrats (10);
Ausbilden eines Qubits (20) über der ersten Oberfläche (11);
Ausbilden mindestens eines Durchgangslochs (14), das das Qubit-Substrat (10) durchdringt, in dem Qubit-Substrat (10);
Ausbilden eines Resists (54) über der ersten Oberfläche (11), um das Qubit (20) und das Durchgangsloch (14) zu bedecken;
Ausbilden eines zweiten leitenden Films (17) über dem ersten leitenden Film (13) und dem Resist (54);
Ausbilden eines ersten Elements (18) über dem zweiten leitfähigen Film (17); und Entfernen des Resists (54) von einer zweiten Oberfläche (12) des Qubit-Substrats (10) über das Durchgangsloch (14) nach dem Ausbilden des ersten Elements (18).

2. Verfahren nach Anspruch 1, wobei
dem zweiten leitenden Film (17) ein Massepotential zugeführt wird.

3. Verfahren nach Anspruch 2, wobei
der erste leitende Film (13) und der zweite leitende Film (17) supraleitende Filme sind.

4. Verfahren nach Anspruch 1 oder 2, weiter umfassend:
Ausbilden eines dritten leitenden Films (15), der mit dem ersten leitenden Film (13) über eine Innenoberfläche des Durchgangslochs (14) gekoppelt ist, wobei dem zweiten leitenden Film (17) über den ersten leitenden Film (13) und den dritten leitenden Film (15) ein Massepotential zugeführt wird.

5. Verfahren nach Anspruch 4, wobei
der erste leitende Film (13), der zweite leitende Film (17) und der dritte leitende Film (15) supraleitende Filme sind.

6. Verfahren nach Anspruch 1 oder 2, wobei
das erste Element (18) ein Film ist, der ein Harz oder einen anorganischen Isolator einschließt.

7. Verfahren nach Anspruch 1 oder 2, wobei
das Ausbilden des Durchgangslochs (14) vor dem Ausbilden des Qubits (20) durchgeführt wird.

8. Verfahren nach Anspruch 1 oder 2, wobei
das Ausbilden des Durchgangslochs (14) nach dem Ausbilden des Qubits (20) durchgeführt wird.

## Revendications

1. Procédé de fabrication d'un dispositif à qubit, comprenant :
la formation d'un premier film conducteur (13) sur une première surface (11) d'un substrat pour qubit (10) ;
la formation d'un qubit (20) sur la première surface (11) ;
la formation d'au moins un trou traversant (14) qui pénètre le substrat pour qubit (10) dans le substrat pour qubit (10) ;
la formation d'un résist (54) sur la première surface (11) de manière à recouvrir le qubit (20) et le trou traversant (14) ;
la formation d'un deuxième film conducteur (17) sur le premier film conducteur (13) et le résist (54) ;
la formation d'un premier élément (18) sur le deuxième film conducteur (17) ; et
le retrait du résist (54) d'une deuxième surface (12) du substrat qubit (10) via le trou traversant (14) après la formation du premier élément (18).

2. Procédé selon la revendication 1, dans lequel
un potentiel de référence est fourni au deuxième film conducteur (17).

3. Procédé selon la revendication 2, dans lequel
le premier film conducteur (13) et le deuxième film conducteur (17) sont des films superconducteurs.

4. Procédé selon la revendication 1 ou la revendication 2, comprenant en outre :
la formation d'un troisième film conducteur (15) couplé au premier film conducteur (13) sur une surface interne du trou traversant (14), dans lequel un potentiel de terre est fourni au deuxième film conducteur (17) par l'intermédiaire du premier film conducteur (13) et du troisième film conducteur (15).

5. Procédé selon la revendication 4, dans lequel
le premier film conducteur (13), le deuxième film conducteur (17) et le troisième film conducteur (15) sont des films superconducteurs.

6. Procédé selon la revendication 1 ou la revendication 2, dans lequel
le premier élément (18) est un film qui inclut une résine ou un isolant inorganique.

7. Procédé selon la revendication 1 ou la revendication 2, dans lequel
la formation du trou traversant (14) est réalisée avant la formation du qubit (20).

8. Procédé selon la revendication 1 ou la revendication 2, dans lequel
la formation du trou traversant (14) est réalisée après la formation du qubit (20).
